# EUROPEAN PATENT SPECIFICATION

(11) **EP 0 694 957 B1**
(45) Date of publication and mention of the grant of the patent: **07.11.2001**
(21) Application number: 94830389.6
(22) Date of filing: 29.07.1994
(51) Int. Cl.: H01L 21/00

(54) **Method for wet processing of semiconductor wafers**
Verfahren zur Behandlung von Halbleiterscheiben mit Flüssigkeiten
Procédé pour traitement dans un liquide de galettes semi-conductrices

(43) Date of publication of application: 31.01.1996
(73) Proprietor: STMicroelectronics S.r.l., 95121 Catania (CT) (IT)
(72) Inventor: Sorbello, Sebastiano, c/o Co. Ri.M.Me., I-95121 Catania (IT)
(74) Representative: Botti, Mario

(56) References cited:
- EP-A- 0 481 723
- US-A- 4 897 369
- US-A- 5 279 316
- IBM TECHNICAL DISCLOSURE BULLETIN., vol.25, no.5, October 1982, NEW YORK US page 2340 RIECKHOFF 'SEMICONDUCTOR WAFER WET PROCESSING ROTATING APPARATUS'
- DE2512588

## Description

The present invention relates to a method for wet treatment of semiconductor slices and specifically for wet washing or etching.

In the production of electronic semiconductor components the material (usually silicon) is cut in the form of discs called commonly slices from which are subsequently cut portions for the production of the various semiconductor devices. Normally the slices must be subjected to etching with various substances to obtain specific characteristics and sometimes they are also subjected to a washing step to remove from their surface traces of foreign substances such as for example ink applied in preceding steps to mark the slices.

Wet etching or washing takes place normally in accordance with one of the following procedures.

A first possibility is to place each slice on a basket and immerse the basket with the slice in the liquid necessary for etching or washing. In the latter case in particular the washing liquid is normally ethylene glycol to which are transmitted ultrasonic vibrations.

A second possibility is to place the slice on a rotating mandrel and flood it with an etching or washing liquid for a predetermined period.

In either case there are imperfections in the treatment due to the resting of the slice against the basket or mandrel.

EP-A-0 481 723 discloses a wafer etching apparatus for etching wafers provided with an orientation flat, composed of a casing, at least five horizontal, parallel and rotative rollers having annular engagement grovees arranged at regulars intervals in the axial direction to receive and support wafers vertically and a press rod means, wherein the rotative rollers are arranged such that the rollers cooperate to circumscribe the wafers, and that when the orientation flat faces any one of the rollers the rest of the rollers cooperate to hold the wafer so as to prevent the orientation flat from coming in contact with the facing roller.

US-A-4 897 369 discloses a method in which the edge of the slices is made to slide in contact with the surfaces of a pad soaked in acid substances and in which, during the process, the areas of the edge of the slices that have been in contact with the pad are periodically washed with a special liquid.

The problem underlying the present invention is to make available a method which would permit performance of wet etching and washing of semiconductor slices in a more effective manner.

This problem has been solved, according to the invention, by the method of appended claim 1.

The rollers of the equipment used in the method according to the invention serve to support a plurality of slices arranged vertically side by side. By rotating the rollers the slices are made to roll in the treatment liquid to help uniform and effective treatment. Specifically there are no areas or points in permanent contact with support elements where the treatment takes place with difficulty.

Furthermore the vertical arrangement of the slices permits simultaneous treatment of a high number thereof thus shortening treatment times.

The treatment liquid will be different depending on the treatment type. Specifically appropriate acids will be employed to obtain etching of the slice or ethylene glycol for ultrasonic washing.

The second motor means for vertical movement of the cage allows a more articulated movement of the slices in the treatment liquid thus helping better flow of the liquid over the totality of the surface of the slices.

Preferably the rollers have a perfectly smooth external surfaces. This prevents accumulation on the rollers of substances which might soil the slices.

Preferably the motor means comprise a gearmotor and a belt transmission active between the gearmotor and at least one of the rollers. Indeed, the rollers immersed in the treatment tank liquid must be connected with the gearmotor placed for practical and safety reasons outside the tank. The solution of a belt transmission ensures both simplicity and hence reliability and the desired separation of rollers and gearmotor.

Preferably the rollers, the gearmotor unit and the belt transmission are supported by the cage. Said components are thus easy to withdraw from the treatment tank all together.

If the treatment is ultrasonic washing the equipment comprises advantageously an external tank containing water and connected to ultrasound generation means with the treatment tank being immersed in the external tank.

Further characteristics and advantages of the method in accordance with the present invention are clarified by the following description of a preferred embodiment thereof given with reference to the annexed drawing which shows a partially cross sectioned perspective view of ultrasonic washing equipment.

In the FIGS. reference number 1 indicates as a whole equipment for ultrasonic washing of round semiconductor slices and specifically silicon and indicated collectively by F.

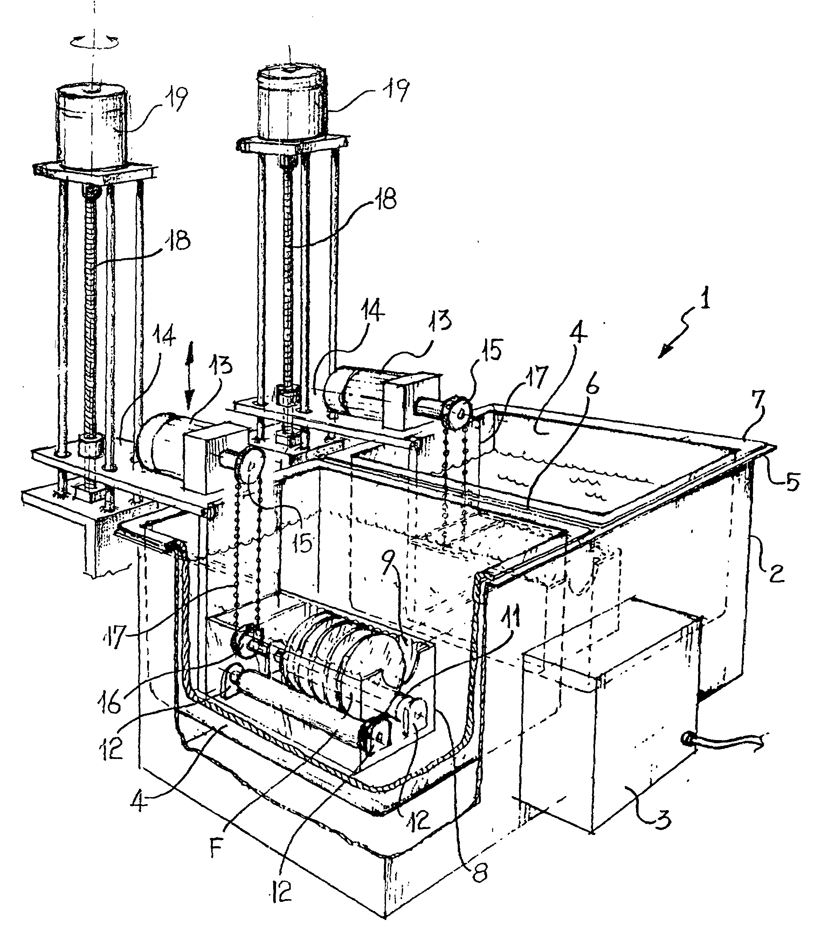

The equipment 1 comprises an external tank 2 of generally parallelepiped form. To the external tank 2 is applied an ultrasound generator 3 of known type and therefore indicated only schematically in the figure.

In the external tank 2 are inserted in a removable manner internal treatment tanks, e.g. two internal tanks 4. There could also be provided a single internal tank or three or more.

The external tank 2 is metallic and full of water while the internal tanks 4 are of quartz and full of a washing liquid such as ethylene glycol.

The internal tanks 4 are also basically parallelepiped in form and housed in the external tank 2 in a suspended manner. For this purpose the external tank 2 is provided with an upper supporting edge 5 integrated with a supporting cross-piece 6 coplanar with the upper supporting edge 5 and extending across the external tank 2 while the internal tanks 4 are provided with a projecting upper edge 7. The internal tanks 4 rest with the projecting upper edge 7 on the upper supporting edge 5 and on the supporting cross-piece 6 of the external tank 2.

In each of the internal tanks 4 is housed in a removable manner a cage 8 i.e. a parallelepiped structure open at bottom and top. The cage 8 is provided with guide and holding means to hold the slices in a vertical position side by side. Said means comprise a plurality of grooves 9 formed in the walls of the cage 8.

In the lower part of the cage 8 is housed a pair of cylindrical rollers 10 and 11 arranged with mutually parallel and virtually horizontal axes. For this purpose the rollers 10 and 11 are mounted on pairs of brackets indicated collectively by 12. Both the rollers 10 and 11 have perfectly smooth external surfaces and are made of Teflon® .

The roller 10 is mounted in an idling manner on its brackets 12 while the roller 11 is provided with motor means. The motor means comprise a gearmotor 13 mounted on a shelf 14 integral with the cage 8 and a belt transmission between the gearmotor 13 and the roller 11. More specifically the belt transmission provides a pulley 15 mounted on the output shaft of the gearmotor 13 and a pulley 16 mounted integrally and coaxially with the roller 11 and a belt 17 mounted on the two pulleys 15 and 16. The belt 17 is the so-called matchboarded type and thus comprises a plurality of matchboards (of Teflon® or equivalent) constrained to a central cable (of Nylon® or equivalent) and spaced a predetermined pitch apart.

The assembly formed by the cage 8 and the shelf 14 is vertically movable in the internal tanks 4 driven by second motor means comprising a worm-gear elevator 18 operated by a second gearmotor 19.

With the equipment 1 washing of slices F from which must be removed traces of ink or other (not shown in the figures) takes place in the following manner.

The slices F are loaded in the cage 8 in virtually vertical position side by side with virtually horizontal axis and guided in the grooves 9. The slices F are thus rested on the rollers 10 and 11.

The operation of loading cage 8 can be performed either with the cage 8 withdrawn from the internal tank 4 or with the cage 8 already immersed in the washing liquid contained in the internal tank 4.

If the slices F to be washed are loaded outside the internal tank 4 the cage 8 (with the motor means mounted on it) is immersed in one of the internal tanks 4 and inserted in turn in the external tank 2 by operating the second gearmotor 19.

When the load of slices F is immersed in the washing liquid the ultrasound generator 3 is activated. The ultrasonic vibrations are transmitted from the ultrasound generator 3 to the walls of the external tank 2, to the water, to the walls of the internal tank 4 and to the washing liquid.

Simultaneously there is operated the gearmotor 13 which rotates the roller 11 and with it the slices F rested thereon. The idling roller 10 contributes only to support of the slices F.

Again simultaneously, there is operated alternately in both directions the second gearmotor 19 so as to give the cage 8 with the slices F to be washed a reciprocating vertical movement.

It was observed that the movement of the slices F during application of ultrasounds helps uniform transmission of vibrations from the washing liquid to the slices thus facilitating detachment of particles of ink from said slices F.

In this manner there is achieved more thorough and faster washing. Simultaneous operation on a relatively high number of slices F also contributes to rapidity of washing.

In case of treatment different from ultrasonic washing the equipment is simplified by elimination of the external tank necessary for ultrasound application. Naturally the material of the treatment tank would be different depending on the treatment liquid to be contained.

For etch treatments with acid substances it is advantageous to be able to insert and withdraw mechanically the slices from the treatment tank thanks to the elevator without the risk of splashing for the operator.

## Claims

1. A method for the wet treatment of round semiconductor slices (F), comprising the step of providing
a treatment tank (4) containing a treatment liquid,
said treatment tank having a cage (8),
a pair of parallel cylindrical rollers (10, 11) having horizontal axis, the rollers (10, 11) being supported at the bottom of the cage and being capable of rotating around their horizontal axis,
at least one of said rollers is being rotated by a motor means (13, 15, 16, 17) (10, 11), the slices (F) being arranged vertically side by side on the rollers (10, 11) so that their axes are substantially horizontal and parallel with the axis of the rollers (10, 11), a said cage (8) being provided for holding the slices (F) in position on the roller (10, 11),
and the step of imparting a reciprocating vertical movement to the cage (8) inside the treatment tank (4) through a second motor means (18, 19) while the slices (F) are being rolled by the rollers (10, 11).

2. A method according to claim 1, wherein said rollers (10, 11) have a perfectly smooth external surface lengthwise.

3. A method according to claim 2, wherein said motor means (13, 15, 16, 17) comprise a gearmotor (13) and a belt transmission (17) active between the gearmotor (13) and at least one of the rollers (10, 11).

4. A method according to claim 3, wherein the rollers (10, 11), the gearmotor unit (13) and the belt transmission (17) are supported by the cage (8).

5. A method according to any one of the preceding claims, wherein said wet treatment includes a ultrasonic washing of said round semiconductor slices (F) and wherein the treatment tank (4) is immersed in an external tank (2), said external tank (2), containing water and being connected to ultrasound generation means.

## Patentansprüche

1. Verfahren zur feuchten Behandlung von runden Halbleiterscheiben (F) umfaßend die Versorgung
eines Behandlungsflüssigkeit enthaltenden Behandlungstanks, (4) der einen Käfig (8) hat,
eines Paares parallelen zylindrischen Walzen (10,11) mit horizontalem Achse, wobei die Walzen (10,11) am Bodenkäfig gestützt und um ihren horizontalen Achsen zu drehen fähig sind,
wobei zumindest eine von den gesagten Walzen (10,11) in Rotation mit Motormittel (13, 15, 16, 17) gesetzt ist, die Scheiben (F) Seite an Seite auf die Walzen (10,11) gestellt sind, so daß ihre Achsen im wesentlichen horizontal und parallel zu der Achse von den Walzen (10,11) sind, und wobei der gesagte Käfig (8) vorgesehen ist, um die Scheiben (F) in Stellung auf den Walzen (10,11) festzuhalten,
und den Schritt, dem in dem Behandlungstank (4) enthaltenen Käfig (8) eine vertikale abwechselnde Bewegung durch zweiten Motormittel (18,19) geben, während die Scheiben (F) von den Walzen (10,11) gedreht werden.

2. Verfahren nach Anspruch 1, in dem die gesagten Walzen eine ganz glatte Außenoberfläche in der Längsrichtung haben.

3. Verfahren nach Anspruch 2, in dem die gesagten Motormittel (13,15,16,17) ein Untersetzungsgetriebe (13) und einen Riemenantrieb (17) umfassen, wobei der Riemenantrieb, zwischen dem Untersetzungsgetriebe (13) und mindestens einem der Walzen (10, 11) aktiv ist.

4. Verfahren nach Anspruch 3, in dem die Walzen, (10,11) das Untersetzungsgetriebe (13) und der Riemenantrieb (17) von dem Käfig (8) gestützt sind

5. Verfahren nach einem der voranstehenden Ansprüche, in dem die gesagte feuchte Behandlung eine Ultraschallwaschung der gesagten runden Halbleiterscheiben (F) umfaßt und in dem der Behandlungstank (4) in einem Außentank (2) getaucht ist, wobei der gesagte Außentank (2) Wasser enthält und mit Ultraschall Generationsmittel verbunden ist.

## Revendications

1. Méthode pour le traitement humide de wafers (F) circulaires de sémiconducteur, comprenant la phase de prévoir
une cuve (4) de traitement contenant un liquide de traitement, ladite cuve de traitement ayant une cage (8),
un couple de rouleaux (10, 11) cylindriques parallèles ayant axe horizontal, les rouleaux (10, 11) étant supportés en correspondance du fond de la cage et capables de tourner autour de leur axe horizontal,
au moins un desdits rouleaux (10, 11) étant mis en rotation par des moyens moteur (13, 15, 16, 17), les wafers (F) étant positionnées verticalement l'une à côté de l'autre sur les rouleaux (10, 11) de façon à ce que leurs axes soient substantiellement horizontaux et parallèles à l'axe des rouleaux (10, 11), ladite cage (8) étant destinée à garder les wafers (F) en position sur les rouleaux (10, 11),
et la phase d'attribution d'un mouvement vertical alternatif à la cage (8) à l'intérieur de la cuve (4) de traitement par l'intermédiaire de deuxièmes moyens moteur (18, 19), les wafers (F) étant mises en rotation par les rouleaux (10, 11).

2. Méthode selon la revendication 1, **caractérisée en ce que** lesdits rouleaux (10, 11) ont une surface extérieure parfaitement lisse dans le sens de la longueur.

3. Méthode selon la revendication 2, **caractérisée en ce que** lesdits moyens moteur (13, 15, 16, 17) comprennent un moto-réducteur (13) et une transmission par courroie (17) active entre le moto-réducteur (13) et au moins un des rouleaux (10, 11).

4. Méthode selon la revendication 3, **caractérisée en ce que** les rouleaux (10, 11), le groupe moto-réducteur (13) et la transmission par courroie (17) sont supportés par la cage (8).

5. Méthode selon l'une quelconque des revendications précédentes,
**caractérisée en ce que** ledit traitement humide comprend un lavage à ultrasons desdites wafers (F) circulaires de sémiconducteur et **en ce que** la cuve (4) de traitement est plongée dans une cuve (2) extérieure, ladite cuve (2) extérieure contenant de l'eau et étant connectée à des moyens de génération d'ultrasons.
